# FASCICULE DE BREVET EUROPEEN

(11) **EP 2 132 786 B1**
(45) Date de publication et mention de la délivrance du brevet: **04.05.2011**
(21) Numéro de dépôt: 08718359.6
(22) Date de dépôt: 31.03.2008
(51) Int. Cl.: H01L 31/052, G02B 5/18

(54) **DISPOSITIF DE CONCENTRATION DE LUMIERE PLAN A EPAISSEUR REDUITE**
FLACHER LICHTKONZENTRATOR MIT GERINGER DICKE
FLAT LIGHT CONCENTRATOR OF SMALL THICKNESS

(30) Priorité: 05.04.2007 FR 0754315
(43) Date de publication de la demande: 16.12.2009
(73) Titulaire: Commissariat à l'Énergie Atomique et aux Énergies Alternatives, 75015 Paris (FR)
(72) Inventeur: THONY, Philippe, 38380 Entre-Deux-Guiers (FR)
(74) Mandataire: Ilgart, Jean-Christophe
(86) Numéro de dépôt international: PCT/EP2008/053817
(87) Numéro de publication internationale: WO 2008/125471

(56) Documents cités:
- US-A- 5 268 985
- US-A- 5 877 874
- US-A- 5 936 777
- US-A1- 2003 154 973

## Description

### DOMAINE TECHNIQUE

La présente invention est relative à un dispositif de concentration de lumière plan à épaisseur réduite. Un tel dispositif peut être associé à une cellule photovoltaïque ou être utilisé de manière indépendante dans le domaine de l'éclairage naturel ou artificiel. L'utilisation d'un dispositif de concentration de lumière dans un dispositif photovoltaïque permet de diminuer la surface de la cellule photovoltaïque pour une même surface illuminée par le soleil. Il permet donc d'abaisser le coût de l'énergie produite.

### ÉTAT DE LA TECHNIQUE ANTÉRIEURE

Les dispositifs de concentration de lumière conventionnels, qui n'ont pas de rôle de transformation du spectre solaire, utilisent des lentilles de Fresnel ou des miroirs paraboliques.

Dans les deux cas, ces composants optiques sont dits primaires et ils coopèrent avec des composants optiques secondaires également de type lentille ou miroir. Les distances focales de ces dispositifs sont grandes. L'encombrement de ces dispositifs est important et ils ne permettent pas d'obtenir, lorsqu'ils sont associés à une cellule photovoltaïque, un ensemble d'épaisseur acceptable pour une application domestique. Dans les dispositifs à miroir parabolique, on place la cellule photovoltaïque au foyer du miroir parabolique, ce qui rend la prise de contact électrique et le refroidissement de la cellule difficile. L'article « Flat high concentration devices » Minano J.C et Al. 24th Conference Photovoltaic Energy Conversion, Dec 5-9, 1994, Hawaii, pages 1123 à 1126, décrit un tel dispositif de concentration de lumière à miroir parabolique.

D'autres dispositifs de concentration de lumière sont intégrés et mixtes. Ils utilisent des dioptres, il s'agit de blocs de matériau transparent pouvant jouer alternativement le rôle de miroir ou de lentille. Les surfaces les plus proches de l'axe optique se comportent comme des lentilles, les surfaces périphériques se comportent comme des miroirs, en produisant une réflexion interne de la lumière. Ces dispositifs mixtes à réfraction et réflexion internes ont une distance focale plus courte relativement à leur taille. La cellule solaire qui coopère avec un tel dispositif est placée en aval du dispositif de concentration. La prise de contact et le refroidissement ne sont pas gênés. Le dispositif de concentration est généralement réalisé par moulage par injection. Il comporte des variations importantes d'épaisseur selon les zones et des arrêtes avec des angles aigus qui ne sont pas forcément aisément réalisables.

Par ailleurs l'éclairement reçu par la cellule photovoltaïque n'est pas uniforme et cela porte un préjudice au rendement de cette dernière et à sa durée de vie. De tels dispositifs de concentration intégrés ont un encombrement moindre, mais cela se fait au prix d'une complexité accrue des surfaces optiques. L'épaisseur du dispositif complet reste néanmoins de plusieurs centimètres. L'article « New developments on the flate-plate micro-concentrator module » Terao, A et Al., 3rd World Conference on Photovoltaic Energy Conversion, May 11-18, 2003 Osaka, Japan, pages 861-864, décrit un tel dispositif de concentration de lumière intégré.

De plus de tels dispositifs de concentration de lumière ont un angle d'acceptance très faible, limité à environ 1 à 3°. On rappelle que l'angle d'acceptance correspond à la valeur limite de l'angle d'incidence des rayons lumineux utiles sur la face avant du dispositif de concentration de lumière. Un suivi mécanique du soleil doit être prévu dans l'application avec une cellule photovoltaïque pour capter le maximum d'énergie.

Plus l'angle d'acceptance est petit, plus la précision du dispositif mécanique doit être grande et plus ce dispositif est coûteux.

Dans ces dispositifs, la face avant des composants optiques doit être protégée et cette protection est difficile voire impossible à mettre en place.

En cas d'une pluralité de composants optiques à agencer en réseau, un alignement précis des composants est requis et le réseau comporte une surface d'entrée complexe.

Leur intégration dans de très grands panneaux solaires est difficile et ces dispositifs semblent plus adaptés à un usage en production centralisée d'énergie, dans des fermes solaires, dans lesquelles on couple une pluralité de panneaux solaires de taille moyenne.

On s'aperçoit également que ces dispositifs de concentration de lumière présentent de médiocres performances en éclairage diffus, notamment lorsque le ciel est nuageux, et ils ne peuvent être employés efficacement que dans des zones très ensoleillées.

Le document US 5 877 874 divulgue un dispositif de concentration de lumière qui comporte une lame ayant deux faces principales et une tranche entre les deux faces principales, et un réseau de diffraction fonctionnant en réflexion qui coopère avec l'une des faces principales de la lame, une zone de sortie de la lumière étant disposée sur la tranche.

Les avantages du dispositif du document US 5 877 874 se fondent sur le multiplexage spatial du réseau de diffraction.

### EXPOSÉ DE L'INVENTION

La présente invention a justement comme but de proposer un dispositif de concentration de lumière qui ne présente pas les inconvénients mentionnés ci dessus.

Un but de l'invention est de proposer un dispositif de concentration de lumière à épaisseur réduite, typiquement inférieure au centimètre. Notamment un tel dispositif de concentration de lumière a une épaisseur sensiblement égale à la largeur de la cellule photovoltaïque avec laquelle il peut coopérer, une cellule solaire conventionnelle a une épaisseur comprise entre environ 100 et 700 micromètres.

Un autre but de l'invention est de proposer un dispositif de concentration de lumière qui soit simple à réaliser et donc bon marché.

Encore un autre but de l'invention est de proposer un dispositif de concentration de lumière qui possède un grand angle d'acceptance de manière à pouvoir fonctionner sans suivi mécanique du soleil.

Un but supplémentaire de l'invention est de proposer un dispositif de concentration de lumière ayant des performances acceptables même en éclairage diffus.

Pour atteindre ces buts, le dispositif de concentration de lumière de l'invention comporte au moins une lame à gradient d'indice qui coopère avec un réseau de diffraction.

Plus précisément, la présente invention est un dispositif de concentration de lumière qui comporte une lame ayant deux faces principales et une tranche entre les deux faces principales, un gradient d'indice de réfraction existant entre les deux faces principales, et
un réseau de diffraction fonctionnant en réflexion ou en semi-réflexion qui coopère avec l'une des faces principales de la lame, celle ayant l'indice de réfraction le plus fort, la face principale ayant l'indice de réfraction le plus faible formant une face avant d'entrée de la lumière, au moins une zone de sortie de la lumière étant disposée sur la tranche.

D'autres aspects de l'invention sont définis dans les revendications dépendantes.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A, 1B montrent, en coupe, un premier exemple d'un dispositif de concentration de lumière selon l'invention ;
la figure 2 montre un exemple de dispositif de concentration de lumière selon l'invention dans lequel le réseau de diffraction est formé de plusieurs sous-réseaux de diffraction;
les figures 3A, 3B montrent des dispositifs photovoltaïques selon l'invention incorporant un dispositif de concentration de lumière selon l'invention ;
les figures 4A, 4B, 4C, 4D montrent encore d'autres exemples de dispositif de concentration de lumière de l'invention ;
les figures 5A, 5B montrent des exemples de dispositif de concentration de lumière à double gradient d'indice selon l'invention ;
la figure 6 montre en trois dimensions encore un exemple de dispositif de concentration de lumière selon l'invention à rendement amélioré ;
les figures 7A à 7E montrent diverses formes de dispositifs photovoltaïques selon l'invention ;
les figures 8A à 8D montrent plusieurs étapes d'un procédé de réalisation d'un dispositif de concentration de lumière selon l'invention et d'un dispositif photovoltaïque incorporant le dispositif de concentration de lumière ;
les figures 9A à 9D montrent d'autres étapes du procédé de réalisation d'un dispositif de concentration de lumière selon l'invention et de réalisation du dispositif photovoltaïque incorporant le dispositif de concentration de lumière ;
les figures 10A à 10C montrent des étapes du procédé de réalisation du dispositif de concentration de lumière à double gradient d'indice de réfraction.

Les différentes variantes décrites doivent être comprises comme n'étant pas exclusives les unes des autres.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

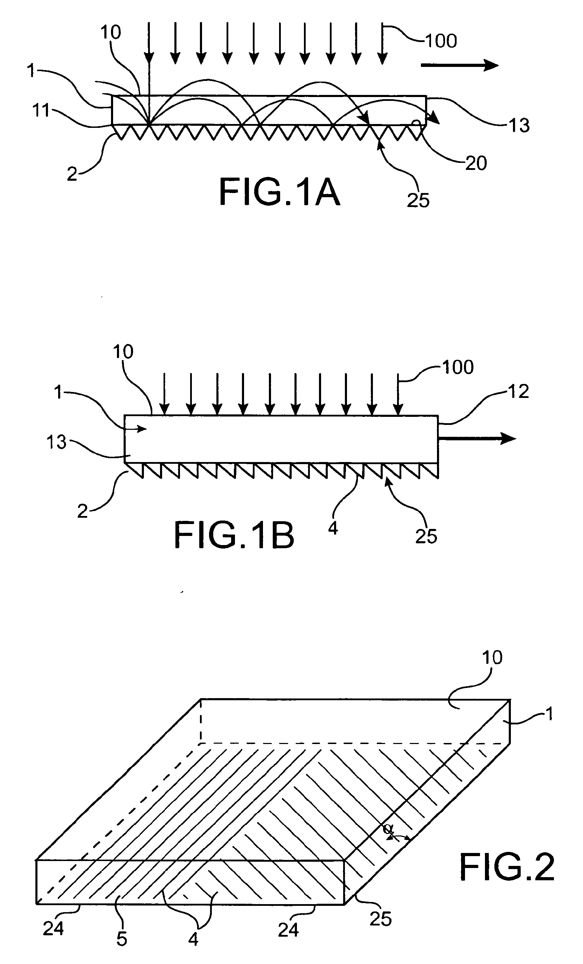

On va maintenant décrire, en se référant à la figure 1A, un premier exemple de dispositif de concentration de lumière conforme à l'invention. Ce dispositif de concentration de lumière comporte, au moins une lame 1 à gradient d'indice de réfraction et au moins un réseau de diffraction 2. Le réseau de diffraction 2 est réfléchissant ou semi-réfléchissant.

Par lame, on entend une plaque laissant passer la lumière, ayant deux faces principales 10, 11 sensiblement planes et parallèles et une tranche 13. La face référencée 10 est dite face avant du dispositif de concentration de lumière. La lame à gradient d'indice de réfraction 1 et le réseau de diffraction 2 sont accolés. L'autre face principale 11 de la lame 1 et une face principale 20 du réseau de diffraction 2 forment une interface entre le réseau de diffraction 2 et la lame 1. L'autre face 25 du réseau de réfraction forme la face arrière du dispositif de concentration de lumière.

L'indice de réfraction de la lame 1 est croissant selon l'épaisseur de la lame 1, depuis la face avant 10 vers l'autre face 11. On a représenté des rayons lumineux 100, interceptés par la face avant 10, qui traversent l'épaisseur de la lame 1 avec une incidence normale. Ils arrivent sur le réseau de diffraction 2 que l'on suppose, dans cet exemple, avoir un indice de réfraction sensiblement constant supérieur ou égal à l'indice le plus fort de la lame 1. Le réseau de diffraction 2 diffracte les rayons lumineux 100 qui ont traversé la lame 1 selon plusieurs ordres de diffraction. Les rayons lumineux diffractés sont réfléchis vers la lame 1 avec un décalage angulaire imposé par le pas du réseau de diffraction 2. Lorsqu'ils pénètrent de nouveau dans la lame 1, les rayons 100 se courbent à cause du gradient de l'indice de réfraction. Certains d'entre eux sont une nouvelle fois réfléchis par le réseau de diffraction 2. Ils sortent du dispositif de concentration de lumière, en ayant subi, pour certains d'entre eux, plusieurs réflexions, par une au moins une zone de sortie 12 disposée sur la tranche 13 de la lame 1.

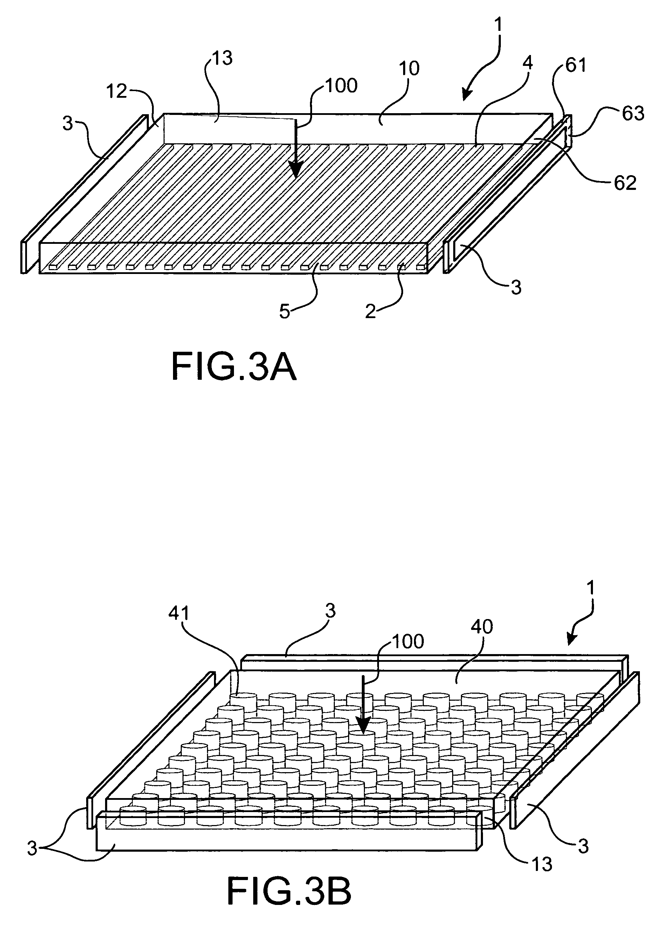

Le réseau de diffraction 2 présente des motifs 4 qui peuvent être unidimensionnels ou bidimensionnels. S'ils sont unidimensionnels, ils sont appelés par la suite traits, ce sont des moulures 4 dont le profil peut être triangulaire, quadrangulaire, trapézoïdal, arrondi ou autre. Deux moulures voisines 4 sont séparées par un espace 5. L'espace 5 n'est pas visible sur la figure 1A, les motifs 4 étant jointifs, par contre on le voit sur les figures 2, 3A. L'espace 5 peut être plein ou vide de matière solide. Il peut prendre la forme d'une tranchée.

S'il s'agit de traits à profil triangulaire, le triangle pouvant être isocèle, rectangle ou quelconque. Un profil triangulaire permet d'améliorer le rendement de diffraction dans un ordre donné pour une plage spectrale donnée. Un profil en triangle rectangle comme illustré sur la figure 1B permet que la lumière soit concentrée dans une seule direction et sorte du dispositif de concentration au niveau d'une seule zone de sortie 12.

Les traits 4 sont sensiblement parallèles et ils peuvent être dirigés selon un bord d'une face principale de la lame 1 comme illustré à la figure 3A.

Il est possible d'accoler plusieurs sous-réseaux de diffraction 24 sur la lame 1 pour en former un. S'il s'agit de sous-réseaux de diffraction 24 à traits 4, les traits des différents sous-réseaux 24 peuvent avoir des directions différentes comme illustré sur la figure 2.

Les traits 4 d'un réseau de diffraction 2 peuvent présenter un angle α différent de 0 et n/2 par rapport à un bord d'une face principale de la lame 1 comme illustré sur la figure 2. Par exemple, l'angle α vaut sensiblement n/4.

Il est également possible que les motifs 4, 40 du réseau de diffraction 2 ne soient pas unidimensionnels mais qu'ils soient bidimensionnels comme illustré à la figure 3B. Les deux figures 3A et 3B ne sont pas à la même échelle et l'échelle des motifs 40 ne correspond pas à celle de la lame 1 pour faciliter la compréhension. Sur la figure 3B, le réseau de diffraction comporte une pluralité de motifs 40 qui sont des plots répartis régulièrement en lignes et colonnes. La figure 3B montre une vue en perspective les plots 40. Les plots 40 sont par exemple, comme illustré, des plots cylindriques à base circulaire. Ils pourraient avoir une base carré, triangulaire ou autre. On peut même envisager que ce soit des cônes éventuellement tronqués.

La figure 3A montre en trois dimensions un dispositif de concentration de lumière selon l'invention associé à au moins deux cellules photovoltaïques 3, ce qui conduit à un dispositif photovoltaïque selon l'invention.

On a représenté deux cellules photovoltaïques 3, chacune d'entre elles est solidaire d'une zone de sortie 12. Ces cellules photovoltaïques 3 ont une surface sensible sensiblement identique aux surfaces des zones de sortie 12 qui leur font face, ici il s'agit de faces de la tranche 13 de la lame 1. La surface totale des cellules photovoltaïques 3 correspond à ce que l'on appellera par la suite la surface utile du dispositif photovoltaïque.

On voit parfaitement sur cette figure 3A que l'épaisseur du dispositif de concentration de lumière 1 n'excède pas la largeur des cellules photovoltaïques 3.

Si les cellules photovoltaïques 3 doivent être refroidies, on voit que ce n'est pas un problème, un dispositif de refroidissement 63, schématisé en pointillés, pourra être aisément monté sur la face arrière 62 de la cellule, cette face arrière 62 étant opposée à celle, référencée 61 qui fait face au dispositif de concentration de lumière. Cette face arrière est parfaitement accessible. Les cellules photovoltaïques 3 sont sensiblement parallèles aux traits 4 du réseau de diffraction 2 ou bien à un axe de symétrie des plots 40. Sur la figure 3B, chacune des faces de la tranche 13 de la lame 1 coopère avec une cellule photovoltaïque 3, dans la mesure où les plots 40 possèdent deux axes de symétrie.

Les motifs 4, 40 des réseaux de diffraction 2 peuvent être réalisés en verre ou en matière plastique par exemple le polystyrène, le polyméthacrylate de méthyle PMMA, le polycarbonate ou d'autres polymères laissant passer la lumière. Le réseau de diffraction 2 présente un contraste d'indice entre ses motifs 4, 40 et l'espace 5 qui les sépare. L'indice de réfraction des motifs 4, 40, dans la mesure où il est constant, est généralement supérieur ou égal à l'indice de réfraction le plus fort de la lame 1. Pour augmenter et contrôler l'indice de réfraction des motifs 4, 40 du réseau de diffraction 2, notamment lorsqu'ils sont en matière plastique, il est possible de charger la matière plastique avec des nanoparticules 30, les nanoparticules 30 pouvant être réalisées à base de silicium, d'oxyde de titane, de sulfure de plomb ou d'alliages II-VI ou III-V. Les alliages II-VI sont des composés comportant des éléments des colonnes II et VI de la classification périodique des éléments parmi lesquels il y a au moins un métal ou un métalloïde.

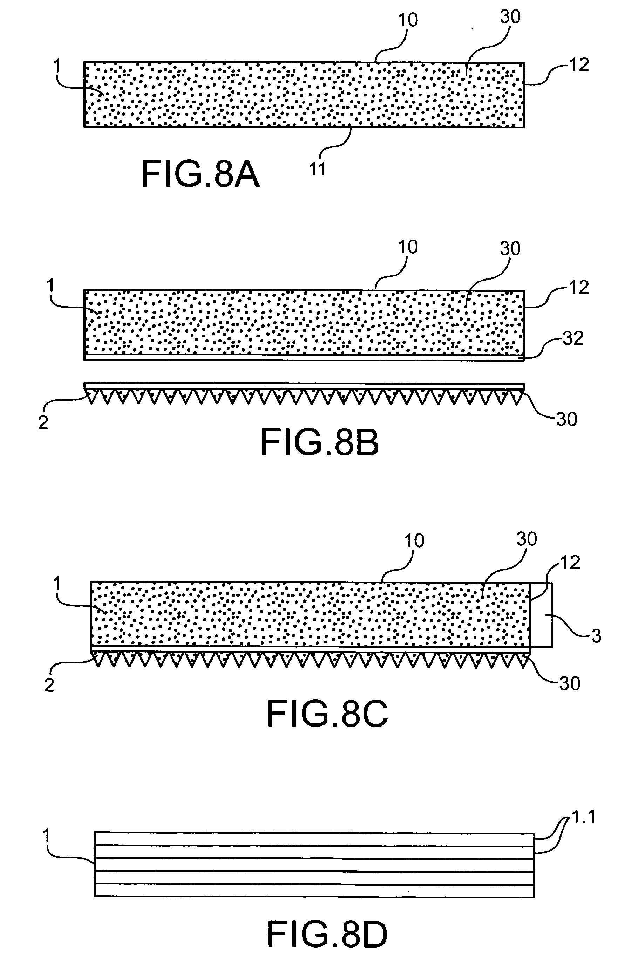

La lame 1 peut être réalisée en verre ou en matière plastique telle que par exemple le polystyrène, le polyméthacrylate de méthyle PMMA, le polycarbonate ou d'autres polymères laissant passer la lumière. La lame 1 peut être chargée en nanoparticules 30, la concentration et la taille des nanoparticules dépendent localement de la valeur de l'indice de réfraction souhaité et cette incorporation des nanoparticules 30 permet de réaliser le gradient d'indice de réfraction comme illustré sur les figures 8.

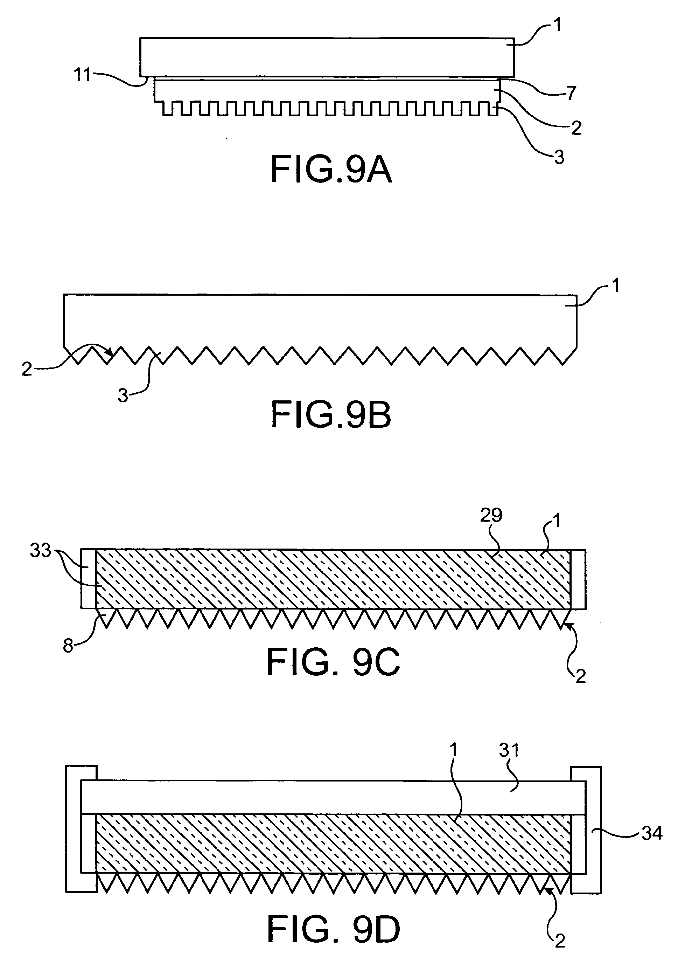

Pour une utilisation en extérieur, notamment dans le cas d'une application dans un dispositif photovoltaïque, il est préférable de prévoir un dispositif de protection avant 31 accolé à la face avant 10 de la lame 1 comme illustré sur la figure 9D. Les matériaux organiques vieillissent lorsqu'ils sont exposés au soleil et aux intempéries. Ils sont en général moins stables que les matériaux inorganiques. Ce dispositif de protection avant 31 peut aussi servir à éviter des dommages tels que des chocs ou des impacts. Ce dispositif de protection avant 31 peut être réalisé par un revêtement déposé sur ou une plaque assemblée à la lame 1. Ce dispositif de protection avant 31 peut en outre avoir un rôle mécanique de support. Ce dispositif de protection avant 31 peut être réalisé par une vitre en verre, ce qui est la solution standard. On la choisit suffisamment transparente et résistante. Certaines matières plastiques pourraient aussi être utilisées comme le polyméthacrylate de méthyle, avec cependant une durée de vie moindre. On prévoit également un cadre 34, par exemple en aluminium qui maintient en périphérie l'ensemble.

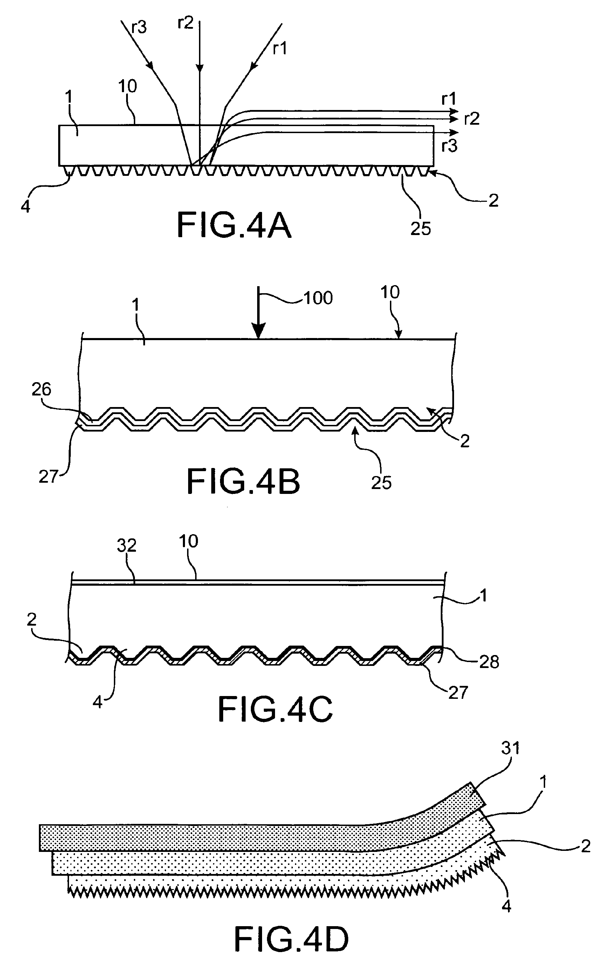

En variante, comme illustré à la figure 4D, il est possible que le dispositif de concentration de lumière soit souple. Ainsi il peut s'adapter sur tout support. A la fois, le dispositif de protection avant 31, la lame 1 (ou les lames s'il y en a plusieurs) et le réseau de diffraction 2 sont réalisés dans une matière plastique souple de type polymère.

La forme de la lame et du dispositif de diffraction ainsi que les matériaux qui les constituent sont adaptées afin de favoriser une intégration optimale du dispositif de concentration de lumière dans un système particulier.

L'épaisseur de la lame 1 peut être comprise être environ 0,5 et 20 millimètres. Les motifs 4, 40 peuvent présenter une hauteur et une largeur comprise entre environ 0,1 et 10 micromètres. L'épaisseur totale du dispositif de concentration de lumière sera alors comprise entre environ 1,5 et 50 millimètres. Cette gamme d'épaisseurs conduit à des épaisseurs bien inférieures à celles des dispositifs de concentration de lumière de l'art antérieur. Sa surface peut être comprise entre environ 25 cm² et 1 m²·

Pour obtenir le gradient d'indice voulu, la lame 1 peut être formée à partir d'un empilement de lamelles 1.1, chacune ayant un indice de réfraction constant, comme on le verra ultérieurement à la figure 8D.

Le gradient d'indice de réfraction de la lame 1 sera supérieur à 0,05. En fait plus le gradient d'indice de réfraction est élevé plus l'acceptance angulaire et spectrale obtenue est élevée. Des rayons inclinés avec des angles d'au moins 50° peuvent être collectés comme illustré sur la figure 4A. Il faut toutefois noter que le facteur de concentration, c'est-à-dire le rapport entre l'énergie qui sort du dispositif de concentration de lumière et l'énergie qui y rentre dépend de l'acceptance angulaire et de la longueur d'onde du rayonnement. Sur la figure 4A, les traits 4 ont un profil quadrangulaire sensiblement en trapèze.

On va donner maintenant des dimensions possibles pour le dispositif de concentration de lumière représenté sur la figure 3A.
- Dimensions de la lame: 150 mm x 150 mm
- Épaisseur de la lame:2 mm
- Valeur du gradient d'indice: 0,29
- Pas du réseau de diffraction 0,5 micromètre
- Angle au sommet d'un trait : 120°

Sur la figure 4A, trois rayons lumineux référencés r1, r2, r3 sont représentés, ils ont chacun une incidence différente par rapport à la face avant 10 de la lame 1. Leurs trajets dans le dispositif de concentration de lumière sont tracés et on les voit émerger de ce dernier. En sortie, ils sont parallèles et rassemblés. Avec un tel dispositif de concentration de lumière, il est possible de collecter de l'énergie lumineuse dans des conditions météorologiques dans lesquelles le ciel est diffus. Il n'est plus nécessaire de prévoir un dispositif mécanique de suivi de soleil, cela conduit à un coût bien moindre qu'auparavant. On suppose que sur la figure 4A, les rayons lumineux r1, r2, r3 ont tous la même longueur d'onde.

Afin d'augmenter le rendement du dispositif de concentration de lumière de l'invention, il est possible de rendre réfléchissante sa face arrière 25, qui correspond à la face du réseau de diffraction 2 opposée à la lame 1. On peut par exemple la recouvrir d'un revêtement réfléchissant arrière 26, par exemple à base d'aluminium ou d'argent. Il est possible de doubler extérieurement ce revêtement réfléchissant arrière 26 d'un revêtement de protection arrière externe 27 qui peut être par exemple en silice. Ce revêtement réfléchissant arrière 26 réfléchit des rayons lumineux 100 qui ont traversé la lame 1 et arrivent jusqu'à la face arrière 25. Le revêtement réfléchissant arrière 26 et le revêtement de protection arrière externe 27 sont visibles sur la figure 4B.

En variante, dans certaines applications, on peut souhaiter que le dispositif de concentration de lumière reste translucide pour un humain tout en ayant un rendement amélioré. Il faut noter que le réseau de diffraction 2 peut éventuellement colorer ou déformer l'image et donc que l'on ne peut voire à travers une image fidèle. Toutefois le dispositif de concentration de lumière peut être utilisé en tant que puits de lumière, par exemple s'il est placé sur le toit d'un bâtiment. Dans ce but, on pourra revêtir la face arrière 25 du dispositif de concentration de lumière d'un revêtement semi-réfléchissant, c'est-à-dire qui est transparent dans le spectre visible pour l'homme du spectre solaire et qui est réfléchissant en dehors du spectre visible. Par exemple, on peut spécifier que le revêtement à une transparence supérieure à environ 90% entre 400 et 700 nanomètres et une transparence d'environ 0% entre 250 et 400 nanomètres et entre 700 et 1100 nanomètres. Les deux bornes 400 et 700 nanomètres sont exclues dans l'une des trois plages. Ces longueurs d'ondes sont bien sûr à adapter en fonction des cellules solaires employées et de l'application choisie. L'ordre zéro du réseau de diffraction 2 permet de voir ce qui se passe du côté de la face arrière 25, avec toutefois un fort chromatisme. Dans cette variante également, on peut prévoir le revêtement de protection arrière externe 27. Pour ne pas multiplier les figures, on suppose que le revêtement 26 sur la figure 4B représente le revêtement réfléchissant arrière ou bien le revêtement semi-réfléchissant arrière.

Il est possible de prévoir que le dispositif de concentration de lumière soit coloré, notamment, si on l'utilise dans un bâtiment et que l'on veut qu'il se fonde dans son environnement. On peut ainsi moduler sa transparence ou la saturation de la couleur. Un revêtement coloré arrière 28 de la face arrière 25 du dispositif de concentration de lumière est représenté sur la figure 4C. Il peut être formé d'un matériau coloré par nature, comme un polymère incluant des pigments ou des phosphores ou encore une peinture. Il peut aussi être formé d'un empilement d'une ou plusieurs couches diélectriques à base par exemple de silice, d'oxyde de titane, de fluorure de magnésium, ou de tout autre matériau utilisé en couche mince en optique pour de la coloration. Le nombre de couches peut être compris par exemple entre un et quatre par exemple. Il est possible de cumuler le revêtement coloré 28 avec le revêtement réfléchissant 26 et/ou le revêtement de protection 27. De plus, sur la figure 4C, on a revêtu la face avant 10 du dispositif de concentration de lumière, du côté de la face 10 ayant l'indice de réfraction le plus faible de la lame 1, d'un revêtement anti-reflet 32. Cela contribue également à améliorer le rendement de collecte.

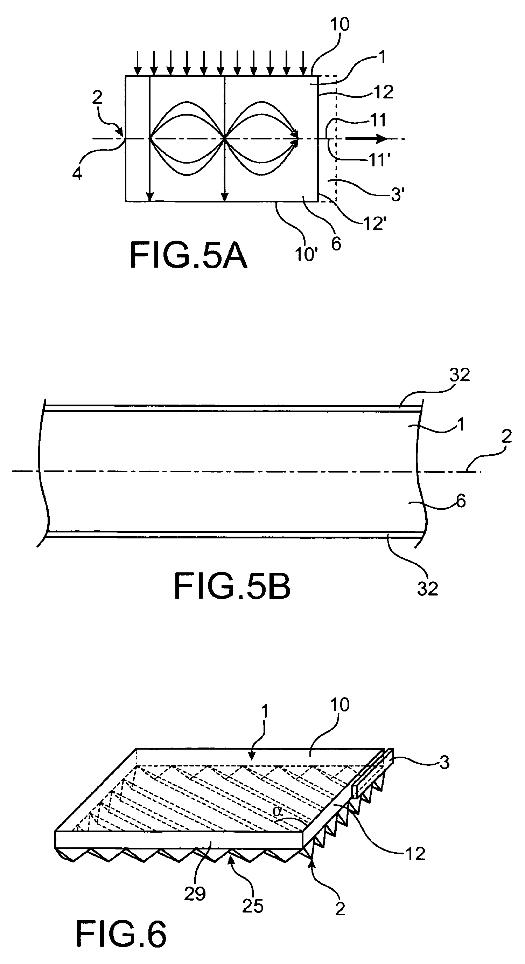

Dans le but de réduire la surface de la zone de sortie 12 du dispositif de concentration de lumière, et donc dans le cas d'une application dans un dispositif photovoltaïque, de réduire sa surface utile, il est possible d'orienter les motifs 4, 40 du réseau de diffraction de manière à ce qu'ils présentent un angle α avec les zones de sortie 12 du dispositif de concentration de lumière. On se réfère à la figure 6. Avec un angle de arctan(2) soit environ 63° ou de arctan(1/2), on réduit la surface de la zone de sortie 12 de moitié.

Plus généralement, on réduit la surface de N si l'angle est arctan(N) ou arctan(1/N).

Plus la surface d'une zone de sortie 12 est petite, plus le nombre de réflexion sur la tranche 13 est grand et plus les pertes risquent d'être élevées lors des réflexions sur la tranche 13.

En outre, on revêt la tranche 13 de la lame 1 d'un revêtement réfléchissant latéral 29, à l'exception de la zone de sortie 12 s'il est opaque. S'il est transparent, on peut le mettre partout. Si la zone de sortie 12 occupe toute une face de la tranche 13, on ne met pas ce revêtement réfléchissant latéral 29 sur cette face. Ce revêtement réfléchissant latéral 29 réfléchit des rayons lumineux se propageant au sein de la lame 1. Plus le revêtement réfléchissant latéral 29 est de bonne qualité, plus les pertes dues à la réflexion seront faibles. Sur la figure 6, on a représenté un tel revêtement réfléchissant latéral 29, qui recouvre totalement trois des faces de la tranche 13 de la lame et la moitié de la dernière face de la tranche 13. Il n'y a qu'une seule cellule photovoltaïque 3 qui n'occupe qu'une portion d'une face latérale de la tranche 13 de la lame 1. On a réduit d'un facteur quatre la surface utile du dispositif photovoltaïque pour une même quantité d'énergie collectée.

Il est possible de prévoir un revêtement de protection latéral externe, référencé 33 figure 9C, sur la tranche 13, il recouvre également les cellules photovoltaïques 3. Il peut être formé par le cadre 34 évoqué plus haut.

Dans le but d'améliorer le rendement du dispositif de concentration de lumière de l'invention, il est préférable de pourvoir au moins une des faces principales 10, 11 de la lame 1 d'un revêtement anti-reflet. Ce revêtement anti-reflet 32 a été déjà été évoqué et sera décrit plus loin dans la description.

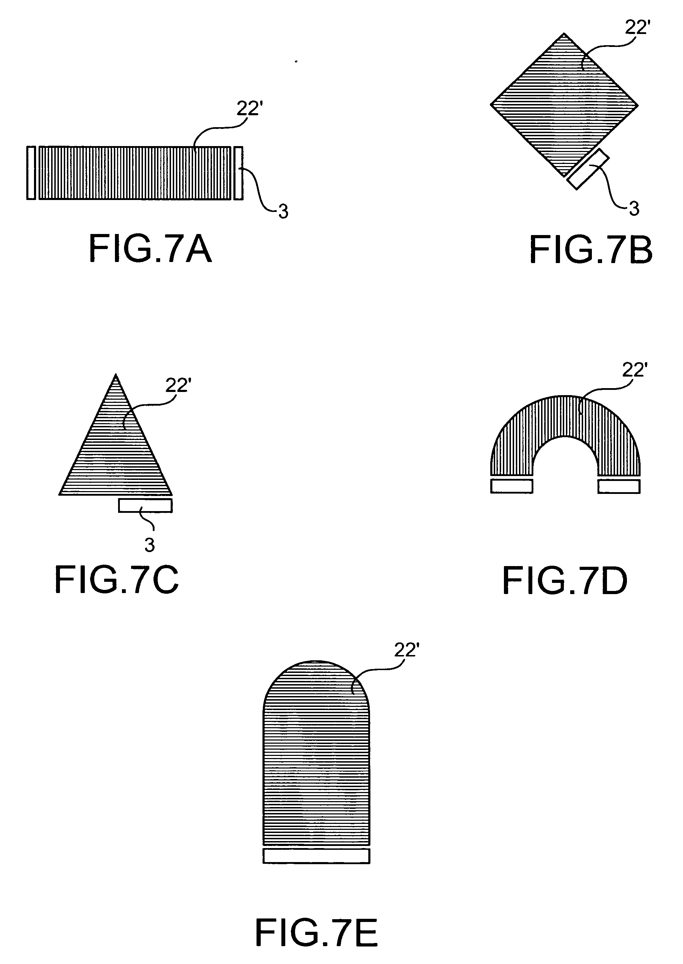

On va maintenant se référer aux figures 7A à 7E qui montrent des exemples, non limitatifs, de formes de lames 1 du dispositif de concentration de lumière de l'invention. On a aussi schématisé des axes de symétrie 22' des motifs du réseau de diffraction et une ou deux cellules photovoltaïques 3 par dispositif. Lorsque les motifs sont des traits, ces derniers sont quasiment confondus avec l'axe de symétrie.

Sur la figure 7A, la lame 1 est un quadrilatère, plus précisément un rectangle, les axes de symétrie 22' des motifs du réseau de diffraction sont parallèles à la largeur de la lame 1, deux cellules photovoltaïques 3 sont représentées, chacune est placée le long d'un bord correspondant à la largeur de la lame. Leur longueur est celle du bord.

Sur la figure 7B, la lame 1 est un quadrilatère, plus précisément un carré, les axes de symétrie 22' des motifs du réseau de diffraction sont parallèles à une diagonale du carré, une seule cellule photovoltaïque 3 est représentée, elle est placée le long d'un des côtés du carré, mais sa longueur est inférieure à celle du côté, elle correspond sensiblement à la moitié du côté.

Sur la figure 7C, la lame 1 est triangulaire, les axes de symétrie 22' des motifs du réseau de diffraction suivent un côté du triangle, une cellule photovoltaïque 3 est placée le long de ce côté et sa longueur est inférieure à celle du côté, elle correspond sensiblement à la moitié du côté.

Sur la figure 7D, la lame 1 est en forme de demi-couronne. Les axes de symétrie 22' des motifs du réseau de diffraction sont parallèles à l'axe de symétrie de la demi-couronne. Il y a deux cellules photovoltaïques 3 placées chacune le long d'un bord d'extrémité de la demi-couronne.

La figure 7E montre une lame 1 en forme de quadrilatère, plus précisément un rectangle, qui se prolonge par un demi-cercle dont le diamètre correspond à un côté du quadrilatère. Les axes de symétrie 22' des motifs du réseau de diffraction sont parallèles à un côté du quadrilatère opposé à celui accolé au demi-cercle. Une cellule photovoltaïque 3 est représentée, placée le long du côté opposé à celui qui est voisin du demi-cercle.

On va maintenant s'intéresser à une autre configuration d'un dispositif de concentration de lumière selon l'invention. On se réfère aux figures 5A et 5B.

Maintenant le dispositif de concentration de lumière comporte deux lames 1 et 6 à gradient d'indice de réfraction prenant en sandwich le réseau de diffraction 2. La première lame 1 comporte une face principale 11 à fort indice de réfraction accolée au réseau de diffraction 2 et une autre face principale 10 à plus faible indice de réfraction. La seconde lame 6 comporte également une face principale 11' à fort indice de réfraction accolée au réseau de diffraction 2 et une autre face principale 10' à plus faible indice de réfraction. Lorsque l'autre face principale 10 de la première lame 1 forme une face avant du dispositif de concentration de lumière, l'autre face principale 10' de la seconde lame 6 forme la face arrière du dispositif de concentration de lumière. L'inverse est possible, la face avant peut se trouver au niveau de la seconde lame 6 et la face arrière au niveau de la première lame 1. Dans les deux lames 1, 6, l'indice de réfraction le plus fort se trouve du côté du côté du réseau de diffraction 2. Un tel réseau de diffraction 2 peut alors fonctionner à la fois en réflexion et en transmission. En plus de ce qui a été décrit à la figure 1A, des rayons lumineux 100 qui pénètrent dans la première lame 1 par la face avant 10 et qui sont diffractés par le réseau de diffraction 2, pénètrent dans la seconde lame 6. Ces rayons 100 se courbent à cause du gradient de l'indice de réfraction. Certains d'entre eux sont une nouvelle fois réfléchis par le réseau de diffraction 2. Ils sortent du dispositif de concentration de lumière, en ayant subi pour certains d'entre eux plusieurs réflexions, par une au moins une zone de sortie 12 disposée sur la tranche 13 de la première lame 1 et/ou sur une zone de sortie 12' disposée sur la tranche de la seconde lame 6. On forme ainsi un véritable guide d'onde de lumière qui amène la lumière à au moins une extrémité du dispositif de concentration de lumière en étant diffractée par le réseau de diffraction et en se propageant dans les lames. De la lumière ayant traversé la première lame 1 et qui n'est pas diffractée par le réseau de diffraction 2, c'est-à-dire correspondant à l'ordre zéro, traverse la seconde lame 6, elle est transmise par le réseau de diffraction 2. Il est alors possible de voir une image correcte de ce qui se passe du côté de la seconde lame de diffraction, lorsque l'on regarde le dispositif de concentration de lumière depuis la première lame.

Les gradients d'indice de réfraction des deux lames 1, 6 peuvent être les mêmes ou différents.

Dans cette configuration, on ne prévoit pas de revêtement réfléchissant sur la face arrière du dispositif de concentration de lumière. Par contre, il est préférable de prévoir un revêtement anti-reflet sur les deux faces principales 10, 10' libres des deux lames 1, 6 à gradient d'indice. Ce revêtement anti-reflet est référencé respectivement 32, 32' sur la figure 5B.

Le revêtement coloré arrière, le revêtement de protection arrière externe et le dispositif de protection avant peuvent se trouver sur la seconde lame 6, dans une configuration à deux lames tout comme le revêtement anti-reflet. Certains de ces revêtements n'ont pas été dessinés dans cette configuration pour ne pas multiplier inutilement les figures. On peut se référer à la figure 5B qui montre un revêtement 32' sur la seconde lame 6.

Sur la figure 5A on a esquissé une cellule photovoltaïque associée au dispositif de concentration de lumière. Elle est référencée 3' et se trouve face à la zone de sortie 12 sur la première lame 1 et également face à la zone de sortie 12' de la seconde lame 6. Bien sûr deux cellules voisines pourraient être utilisées.

On va énumérer maintenant des avantages du dispositif de concentration de lumière de l'invention. Il possède un faible encombrement notamment en épaisseur, il peut prendre une grande variété de formes, et cette forme peut être adaptée à un support qui est destiné à le recevoir. On peut par exemple penser à une tuile de toit, un cadre devant délimiter un puits de lumière ou un autre élément d'un bâtiment tel qu'un volet. On peut choisir sa transparence dans une large gamme. C'est intéressant notamment dans l'application puits de lumière. La variante des figures 5, convient particulièrement lorsque l'on recherche un dispositif de concentration de lumière transparent. On peut choisir sa couleur dans une large gamme, c'est intéressant notamment dans l'habitat pour l'intégrer dans un environnement de couleur donnée. Puisqu'il peut fonctionner sans dispositif mécanique de suivi du soleil, il est plus facile à intégrer dans un système quelconque. Le dispositif de concentration de lumière a des performances accrues en cas d'éclairage diffus.

Dans l'application dans un dispositif photovoltaïque, on peut réduire la quantité de matériau semi-conducteur utilisé, puisque la surface utile peut être réduite. On peut réduire le coût de production de l'énergie puisque on peut se passer du dispositif mécanique du suivi de soleil. Par ailleurs, le dispositif de concentration de lumière de l'invention, du fait des réflexions multiples, permet de répartir l'éclairage sur l'ensemble de la cellule photovoltaïque, améliorant ainsi sa durée de vie.

On va maintenant décrire un exemple de procédé de fabrication d'un tel dispositif de concentration de lumière et d'un dispositif photovoltaïque.

On part d'une lame 1 à gradient d'indice de réfraction, le gradient étant croissant le long de son épaisseur (figure 8A). Elle possède deux faces principales 10, 11 et une tranche 13. On la fait coopérer avec un réseau de diffraction 2 placé, au niveau de sa face principale 11 ayant l'indice de réfraction le plus fort (figure 8B). Pour obtenir un dispositif photovoltaïque, on monte au moins une cellule photovoltaïque 3 au niveau d'une zone de sortie 12 du dispositif de concentration de lumière qui se trouve sur la tranche de la lame 1, par exemple par collage (figure 8C).

Sur les figures 8B et 8C, on suppose que des nanoparticules 30 sont incorporées dans les motifs 3 du réseau de diffraction 2 et la lame 1 pour atteindre un indice de réfraction et une variation voulus.

La lame à gradient d'indice 1 peut être monolithique (comme sur la figure 8A) ou être formée par un empilement de lamelles 1.1 ayant des indices de réfraction différents (figure 8D). Ces lamelles 1.1 sont assemblées entre elles par exemple par collage avec une colle (connue sous la dénomination anglo-saxonne de « glass fuser glue ») ou par assemblage moléculaire sans colle. On prévoit ensuite une étape de fusion et d'élimination des interfaces entre les lamelles 1.1 par interdiffusion, si de la colle a été employée ou aussi s'il y a eu assemblage moléculaire.

La coopération entre la lame 1 et le réseau de diffraction 2 peut se faire par report du réseau de diffraction 2 sur la face principale 11 de la lame 1 à fort indice de réfraction comme illustré sur la figure 9A.

Le réseau de diffraction 2 peut être fabriqué par moulage, par embossage ou par des techniques de lithogravure ou par holographie.

Le réseau de diffraction 2 peut être reporté individuellement, ou collectivement par collage sur une grande lame et l'ensemble sera ensuite subdivisé en plusieurs morceaux. La colle est référencée 7 sur la figure 9A.

En variante, le réseau de diffraction 2 peut être formé dans la lame 1 à gradient d'indice, du côté à fort indice de réfraction de la lame 1, par gravure par exemple par gravure sèche ou humide après lithographie, par tracé mécanique comme illustré à la figure 9B ou même par ablation laser ou même embossage. On peut même envisager de réaliser le réseau de diffraction 2 sur la lame 1 par une étape d'embossage d'une couche de polymère 8 déposée préalablement sur la lame 1, côté haut indice de réfraction, comme illustré à la figure 9C. La couche de polymère 8 n'est vue qu'après l'embossage.

Dans la configuration de la figure 9B, les motifs 3 du réseau de diffraction 2 sont à gradient d'indice de réfraction et plus à indice de réfraction constant.

On peut prévoir de former sur une partie au moins de la tranche 13 de la lame 1 un revêtement réfléchissant latéral 29. Ce revêtement réfléchissant latéral 29 peut être fait à base d'aluminium ou d'argent. Ce revêtement réfléchissant latéral 29 peut être obtenu par pulvérisation ou par évaporation et être réalisé avant ou après la fixation du réseau de diffraction 2 à la lame ou avant ou après la réalisation du réseau de diffraction 2 sur ou au sein de la lame 1.

La partie dotée du revêtement réfléchissant latéral 29 peut correspondre à toute la tranche 13 de la lame 1 si le revêtement est transparent, s'il est opaque au moins une zone de sortie 12 qui sera face à la cellule photovoltaïque 3 est épargnée. Ce revêtement réfléchissant latéral 29 est matérialisé sur la figure 9A par les hachures en pointillés. Il est également possible d'adjoindre au revêtement réfléchissant latéral 29 un revêtement de protection latéral externe 33. Ce revêtement de protection externe 33 peut être réalisé par exemple en silice et obtenu par pulvérisation ou en polymère et obtenu par trempage ou dépôt liquide. Le revêtement de protection 33 peut être global et protéger tout le dispositif de concentration de lumière.

On peut prévoir de former, par exemple par pulvérisation ou dépôt sol-gel, un revêtement réfléchissant ou semi-réfléchissant arrière 26 sur la face arrière 25 du dispositif de concentration de lumière. Ce revêtement réfléchissant ou semi-réfléchissant arrière 26 peut être présent sur le réseau de diffraction 2 avant de l'assembler à la lame 1 ou être réalisé après. Lorsque le réseau de diffraction 2 est formé sur ou au sein de la lame 1, le revêtement réfléchissant ou semi-réfléchissant arrière 26 sera réalisé après formation du réseau de diffraction 2. Le revêtement réfléchissant arrière 26 peut être réalisé à base d'aluminium ou d'argent par exemple. Le revêtement semi-réfléchissant arrière 26 peut être réalisé par exemple à base de silice, de nitrure de silicium, d'oxyde de titane, de fluorure de magnésium, d'oxyde de tantale. Ce revêtement réfléchissant ou semi-réfléchissant arrière 26 est visible sur la figure 4B.

On peut prévoir de former un revêtement coloré arrière 28 sur la face arrière 25 du dispositif de concentration de lumière. Ce revêtement coloré arrière 28 peut être présent sur le réseau de diffraction 2 avant de l'assembler à la lame 1 ou être réalisé après ou après la réalisation du réseau de diffraction sur ou au sein de la lame 1. Ce revêtement coloré 28 est visible sur la figure 4C. Il peut être réalisé par exemple par pulvérisation, dépôt sol-gel, dépôt à la tournette, trempage et être formé d'une ou plusieurs couches de matériaux qui peuvent être transparents par nature ou au contraire naturellement colorés comme des peintures ou des matériaux incluant des ions terres rares ou des phosphores ou des particules fluorescentes. Ces matériaux peuvent par exemple être choisis parmi la silice, l'oxyde de titane, le fluorure de magnésium ou de tout autre matériau diélectrique connu pour apporter une couleur. L'empilement des différents matériaux avec différentes épaisseurs et selon différentes séquences conduira à une couleur donnée interférentielle.

On peut également prévoir que le revêtement coloré 28 comporte au moins une couche de matériau neutre tel que de la silice ou un polymère de type PMMA incorporant des grains de luminophore.

Le revêtement coloré arrière 28 peut être associé au revêtement de protection arrière externe 27.

On peut prévoir de réaliser un revêtement anti-reflet 32 sur au moins une des faces principales 10, 11 de la lame 1, et s'il y en a qu'un, on le met sur la face avant 10 de la lame 1, côté bas indice de réfraction. C'est notamment le cas si le réseau de diffraction est formé au sein de la lame 1.

Lorsque le réseau de diffraction 2 est reporté sur la lame 1 ou formé sur la lame 1, on peut également pourvoir l'autre face principale 11 de la lame 1 qui va recevoir le réseau de diffraction 2 du revêtement anti-reflet 32 avant le report ou la formation du réseau de diffraction comme illustré sur la figure 8B. Ce revêtement anti-reflet 32 peut être mono-couche ou multicouche.

Le revêtement anti-reflet 32 peut être réalisé à partir d'un empilement d'une ou plusieurs couches transparentes d'un matériau choisi par exemple parmi la silice, l'oxyde de titane, le fluorure de magnésium, comme pour le revêtent coloré, ou de tout autre matériau diélectrique connu pour ses propriétés d'anti-reflet.

Le revêtent coloré peut être, à la base le même que le revêtement anti-reflet , mais conçu de façon différente. Il utilise les mêmes matériaux, avec une séquence d'empilement différente et des épaisseurs différentes. Cependant, le revêtement coloré peut en plus utiliser des matériaux colorés par nature, par exemple des matériaux présentant des impuretés tels que des terres rares, des nanoparticules, des phosphores.

On peut disposer sur la face avant du dispositif de concentration de lumière, un dispositif de protection avant 31, cela peut se faire par collage. Ce dispositif de protection avant 31 peut être une plaque de verre ou une plaque de matière plastique telle que le polyméthacrylate de méthyle. On se réfère à la figure 9D. La lame 1 et/ou le réseau de diffraction 2 peuvent alors être réalisés en matière plastique. Un cadre métallique 34 peut cercler l'ensemble.

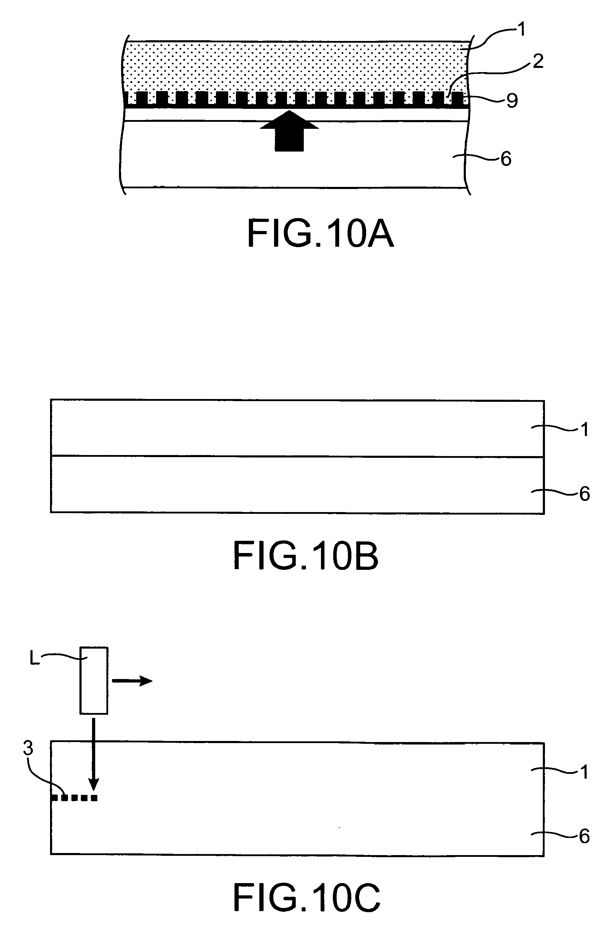

Lorsque le dispositif de concentration de lumière est un sandwich avec deux lames 1, 6 et que le réseau de diffraction 2 est inséré entre elles, il est possible que la seconde lame 6 soit rapportée sur le réseau de diffraction 2 après que celui-ci ait été associé à la première lame 1 comme illustré à la figure 10A. Le réseau de diffraction 2 aura pu être imprimé en relief sur la première lame 1, du côté de son indice de réfraction le plus grand.

Dans ce cas, on remplit les espaces 5 entre les motifs 3 du réseau de diffraction 2 avec un matériau de remplissage 9 présentant un contraste d'indice de réfraction avec celui des motifs 3 du réseau de diffraction 2. Ce matériau peut être un matériau diélectrique (silice, nitrure de silicium ou autre) ou un polymère ou un matériau hybride organique/inorganique et avoir un indice de réfraction plus petit que celui des motifs. Ce matériau peut déborder des tranchées mais ce n'est pas une nécessité. Un autre mode de réalisation peut aussi être envisagé. On peut assembler entre elles les deux lames 1, 6, par leur face présentant l'indice de réfraction le plus élevé (figure 10B), par exemple par collage ou adhésion moléculaire sans colle. On prévoit ensuite une étape de fusion pour faire disparaître l'interface. Ces deux lames 1, 6 peuvent être monolithiques ou un empilement de lamelles d'indice de réfraction différents comme expliqué plus haut. Dans ce dernier cas, les lamelles peuvent être placées, selon leur indice de réfraction, de manière symétrique par rapport à l'interface. On obtient alors un guide de lumière, chacune des lames 1, 6 formant un demi guide de lumière.

Le réseau de diffraction peut être formé par endommagement ou refusion au centre de l'assemblage, par exemple par un laser L focalisé au centre du guide (figure 10 C).

Bien que plusieurs modes de réalisation de la présente invention aient été représentés et décrits de façon détaillée, on comprendra que différents changements et modifications puissent être apportés sans sortir du cadre de l'invention.

## Revendications

1. Dispositif de concentration de lumière, comportant :
une lame (1) ayant deux faces principales (10, 11) et une tranche (13) entre les deux faces principales (10, 11), un gradient d'indice de réfraction existant entre les deux faces principales (10, 11), et
un réseau de diffraction (2) fonctionnant en réflexion ou en semi-réflexion qui coopère avec l'une des faces principales (11) de la lame, celle ayant l'indice de réfraction le plus fort, la face principale (10) ayant l'indice de réfraction le plus faible formant une face avant d'entrée de la lumière, au moins une zone de sortie (12) de la lumière étant disposée sur la tranche (13).

2. Dispositif de concentration de lumière selon la revendication 1, dans lequel lorsque le réseau de diffraction comporte des motifs unidimensionnels, ce sont des traits sensiblement parallèles.

3. Dispositif de concentration de lumière selon la revendication 1, dans lequel lorsque le réseau de diffraction comporte des motifs bidimensionnels (40), ce sont des plots de forme cylindrique ou conique.

4. Dispositif de concentration de lumière selon l'une des revendications 1 à 3, dans lequel le réseau de diffraction comporte plusieurs sous-réseaux de diffraction ayant des motifs présentant des orientations différentes.

5. Dispositif de concentration de lumière selon l'une des revendications précédentes, dans lequel la tranche (13) est formée de plusieurs faces latérales, la zone de sortie (12) occupant toute une face latérale ou seulement une portion.

6. Dispositif de concentration de lumière selon l'une des revendications 1 à 5, dans lequel le réseau de diffraction (2) comporte des motifs (4) qui ont un indice de réfraction sensiblement constant, supérieur ou égal à l'indice de réfraction le plus fort de la lame (1).

7. Dispositif de concentration de lumière selon l'une des revendications 1 à 5, dans lequel le réseau de diffraction (2) comporte des motifs (4) à gradient d'indice de réfraction entre une face principale (20) qui coopère avec la lame (1) et une autre face principale (25) opposée à celle qui coopère avec la lame (1).

8. Dispositif de concentration de lumière selon l'une des revendications précédentes, dans lequel une face arrière (25) du dispositif de concentration de lumière est une face du réseau de diffraction (2) située à l'opposé de la face ayant l'indice de réfraction le plus faible de la lame (1), cette face arrière (25) étant pourvue d'un revêtement réfléchissant ou semi-réfléchissant arrière (26).

9. Dispositif de concentration de lumière selon l'une des revendications 1 à 7, dans lequel une autre lame (6) à gradient d'indice, ayant deux faces principales et une tranche, et la lame à gradient d'indice (1) forment un sandwich dans lequel se trouve le réseau de diffraction (2), le réseau de diffraction étant du côté de la face principale ayant l'indice de réfraction le plus grand de l'autre lame, la tranche de l'autre lame étant pourvue d'au moins une zone (12') de sortie de lumière.

10. Dispositif de concentration de lumière selon l'une des revendications précédentes, possédant une face arrière (25) à l'opposé de la face principale ayant l'indice de réfraction le plus faible de la lame (1) ou de l'une des lames (1, 6), dans lequel la face arrière (25) est pourvue d'un revêtement coloré arrière (28) destiné à colorer le dispositif de concentration de lumière.

11. Dispositif de concentration de lumière selon l'une des revendications précédentes, dans lequel la face principale (10) ayant l'indice de réfraction le plus faible de la lame (1) ou d'au moins l'une des lames (1, 6) est pourvue d'un revêtement anti-reflet (32), la face principale (11) ayant l'indice de réfraction le plus fort de la lame (1) ou d'au moins l'une des lames (1, 6) pouvant également être pourvue d'un revêtement anti-reflet (32).

12. Dispositif de concentration de lumière selon l'une des revendications précédentes, dans lequel la tranche (13) de la lame (1) ou d'au moins l'une des lames (1, 6) est pourvue d'un revêtement réfléchissant latéral (29), à l'exception de la zone de sortie (12) s'il est opaque.

13. Dispositif de concentration de lumière selon l'une des revendications précédentes, dans lequel le réseau de diffraction (2) et la lame (1) ou les lames (1, 6) sont souples.

14. Dispositif photovoltaïque comportant un dispositif de concentration de lumière selon l'une des revendications 1 à 13 et une cellule photovoltaïque (3) montée sur chaque zone de sortie (12).

## Claims

1. Light concentration device, comprising:
a plate (1) having two principal faces (10, 11) and an edge (13) between the two principal faces (10, 11), a refractive index gradient existing between the two principal faces (10, 11), and
a diffraction grating (2) functioning in reflection or semi-reflection that cooperates with one of the principal face (11) of the plate, the one having the highest refractive index, the principal face (10) having the lowest refractive index forming a front entry face for the light, at least one exit zone (12) for the light being disposed on the edge (13).

2. Light concentration device according to claim 1, in which when the diffraction grating comprises unidimensional patterns, they are substantially parallel lines.

3. Light concentration device according to claim 1, in which when the diffraction grating comprises bidimensional patterns, they are cylindrically or conically shaped studs.

4. Light concentration device according to one of claims 1 to 3, in which the diffraction grating comprises several diffraction sub-gratings having patterns with different orientations.

5. Light concentration device according to one of the preceding claims, in which the edge (13) is formed by several lateral faces, the exit zone (12) occupying an entire lateral face or only a portion.

6. Light concentration device according to one of claims 1 to 5, in which the diffraction grating (2) comprises patterns (4) which have a substantially constant refractive index, greater than or equal to the highest refractive index of the plate (1).

7. Light concentration device according to one of claims 1 to 5, in which the diffraction grating (2) comprises refractive index gradient patterns between a principal face (20) that cooperates with the plate (1) and another principal face (25) opposite to the one that cooperates with the plate (1).

8. Light concentration device according to one of the preceding claims, in which a rear face (25) of the light concentration device is a face of the diffraction grating (2) situated opposite to the face having the lowest refractive index of the plate (1), this rear face (25) being provided with a rear reflective or semi-reflective coating (26).

9. Light concentration device according to one of claims 1 to 7, in which another plate (6) with an index gradient, having two principal faces and an edge, and the plate with an index gradient (1) form a sandwich in which the diffraction grating (2) is situated, the diffraction grating being on the same side as the principal face having the highest refractive index of the other plate, the edge of the other plate being provided with at least one light exit zone (12').

10. Light concentration device according to one of the preceding claims, having a rear face (25) opposite to the principal face having the lowest refractive index of the plate (1) or of one of the plates (1, 6), in which the rear face (25) is provided with a rear coloured coating (28) intended to colour the light concentration device.

11. Light concentration device according to one of the preceding claims, in which the principal face (10) having the lowest refractive index of the plate (1) or of at least one of the plates (1, 6) is provided with an anti-reflection coating (32), the principal face (11) having the highest refractive index of the plate (1) or of at least one of the plates (1, 6) also being able to be provided with an anti-reflection coating (32).

12. Light concentration device according to one of the preceding claims, in which the edge (13) of the plate (1) or of at least one of the plates (1, 6) is provided with a lateral reflective coating (29), with the exception of the exit zone (12) if it is opaque.

13. Light concentration device according to one of the preceding claims, in which the diffraction grating (2) and the plate (1) or plates (1, 6) are flexible.

14. Photovoltaic device comprising a light concentration device according to one of claims 1 to 13 and a photovoltaic cell (3) mounted on each exit zone (12).

## Patentansprüche

1. Lichtkonzentrationsvorrichtung, umfassend:
Eine Platte (1) mit zwei Hauptflächen (10, 11) und einer Seite (13) zwischen den zwei Hauptflächen (10, 11), wobei ein Brechungsindexgradient zwischen den zwei Hauptflächen (10, 11) existiert, und
ein Beugungsgitter (2), das in Reflexion oder in Semireflexion funktioniert und mit einer der Hauptflächen (11) der Platte zusammenwirkt, nämlich jener mit dem größeren Brechungsindex, wobei die Hauptfläche (10) mit dem kleineren Brechungsindex eine vordere Lichteintrittsfläche bildet, wobei wenigstens eine Austrittszone (12) des Lichts auf der Platte (13) angeordnet ist.

2. Lichtkonzentrationsvorrichtung nach Anspruch 1, bei der, wenn das Beugungsgitter eindimensionale Motive umfasst, dies im Wesentlichen parallele Striche sind.

3. Lichtkonzentrationsvorrichtung nach Anspruch 1 bei der, wenn das Beugungsgitter zweidimensionale Motive (40) umfasst, dies Stifte mit zylindrischer oder konischer Form sind.

4. Lichtkonzentrationsvorrichtung nach einem der Ansprüche 1 bis 3, bei der das Beugungsgitter mehrere Unter-Beugungsgitter mit Motiven umfasst, die verschiedene Orientierungen aufweisen.

5. Lichtkonzentrationsvorrichtung nach einem der vorhergehenden Ansprüche, bei der die Platte (13) mit mehreren lateralen Flächen ausgebildet ist, wobei die Austrittszone (12) eine gesamte laterale Fläche oder nur einen Teil belegt.

6. Lichtkonzentrationsvorrichtung nach einem der Ansprüche 1 bis 5, bei der das Beugungsgitter (2) Motive (4) umfasst, die einen im Wesentlichen konstanten Brechungsindex aufweisen, der größer oder gleich dem größten Brechungsindex der Platte (1) ist.

7. Lichtkonzentrationsvorrichtung nach einem der Ansprüche 1 bis 5, bei der das Beugungsgitter (2) Motive (4) mit einem Brechungsindexgradienten zwischen einer Hauptfläche (20), die mit der Platte (1) zusammenwirkt, und einer anderen Hauptfläche (25) umfasst, die jener entgegengesetzt ist, die mit der Platte (1) zusammenwirkt.

8. Lichtkonzentrationsvorrichtung nach einem der vorhergehenden Ansprüche, bei der eine Rückfläche (25) der Lichtkonzentrationsvorrichtung eine Fläche des Beugungsgitters (2) ist, die derjenigen Fläche entgegengesetzt angeordnet ist, die den kleinsten Brechungsindex der Platte (1) aufweist, wobei diese Rückfläche (25) mit einer reflektierenden oder semi-reflektierenden rückwärtigen Beschichtung (26) ausgestattet ist.

9. Lichtkonzentrationsvorrichtung nach einem der Ansprüche 1 bis 7, bei der eine andere Platte (6) mit einem Indexgradienten, die zwei Hauptflächen und eine Seite aufweiset, sowie die Platte mit dem Indexgradienten (1) ein Sandwich bilden, in welchem sich das Beugungsgitter (2) befindet, wobei das Beugungsgitter sich auf der Seite der Hauptfläche der anderen Platte mit dem größeren Brechungsindex befindet, wobei die Seite der anderen Platte mit wenigstens einer Lichtaustrittszone (12') versehen ist.

10. Lichtkonzentrationsvorrichtung nach einem der vorhergehenden Ansprüche, die eine Rückfläche (25) besitzt, welche der Hauptfläche der Platte (1) oder einer der Platten (1, 6) mit dem kleineren Brechungsindex entgegengesetzt ist, wobei die Rückfläche (25) mit einer farbigen rückwärtigen Beschichtung (28) versehen ist, die dazu bestimmt ist, der Lichtkonzentrationsvorrichtung Farbe zu verleihen.

11. Lichtkonzentrationsvorrichtung nach einem der vorhergehenden Ansprüche, bei der die Hauptfläche (10) mit dem kleineren Brechungsindex der Platte (1) oder wenigstens einer der Platten (1, 6) mit einer Antireflexionsbeschichtung (32) versehen ist, wobei die Hauptfläche (11) mit dem größten Brechungsindex der Platte (1) oder wenigstens einer der Platten (1, 6) ebenfalls mit einer Antireflexionsbeschichtung (32) versehen sein kann.

12. Lichtkonzentrationsvorrichtung nach einem der vorhergehenden Ansprüche, wobei die Seite (13) der Platte (1) oder wenigstens einer der Platten (1, 6) mit einer lateralen reflektierenden Beschichtung (29) versehen ist, ausgenommen die Austrittszone (12), wenn sie opak ist.

13. Lichtkonzentrationsvorrichtung nach einem der vorhergehenden Ansprüche, bei der das Beugungsgitter (2) und die Platte (1) oder die Platten (1, 6) flexibel sind.

14. Photovoltaische Vorrichtung, umfassend eine Lichtkonzentrationsvorrichtung nach einem der Ansprüche 1 bis 13 sowie eine photovoltaische Zelle (3), die auf jeder Austrittszone (12) montiert ist.
